(19) Europäisches Patentamt
European Patent Office
Office européen des brevets

(11) EP 4 549 526 A1

(12) **EUROPEAN PATENT APPLICATION**

(43) Date of publication:
07.05.2025 Bulletin 2025/19

(21) Application number: 24210849.6

(22) Date of filing: 05.11.2024

(51) International Patent Classification (IPC):
C09G 1/02 (2006.01) C09K 3/14 (2006.01)

(52) Cooperative Patent Classification (CPC):
C09G 1/02; C09K 3/1463

(84) Designated Contracting States:
AL AT BE BG CH CY CZ DE DK EE ES FI FR GB GR HR HU IE IS IT LI LT LU LV MC ME MK MT NL NO PL PT RO RS SE SI SK SM TR
Designated Extension States:
BA
Designated Validation States:
GE KH MA MD TN

(30) Priority: 06.11.2023 KR 20230151792

(71) Applicants:
• SK enpulse Co., Ltd.
Pyeongtaek-si, Gyeonggi-do 17784 (KR)
• SK Hynix Inc.
Icheon-si, Gyeonggi-do 17336 (KR)

(72) Inventors:
• HAN, Deok Su
03142 Seoul (KR)
• CHO, Jong Young
17336 Icheon-si, Gyeonggi-do (KR)
• KIM, Woo Joo
17336 Icheon-si, Gyeonggi-do (KR)
• KANG, Hyun Goo
17336 Icheon-si, Gyeonggi-do (KR)
• LEE, Dong Kyun
17336 Icheon-si, Gyeonggi-do (KR)

(74) Representative: BCKIP Part mbB
MK1
Landsbergerstraße 98, 3.Stock
80339 München (DE)

(54) **POLISHING COMPOSITION FOR SEMICONDUCTOR PROCESS AND MANUFACTURING METHOD OF SUBSTRATE USING THE SAME**

(57) A polishing composition for a semiconductor process includes polishing particles, a polishing pad protectant, and a fluorinated surfactant. The polishing composition for the semiconductor process has an Rm/e value of 2.5 % or less, which is a ratio of a number of defects derived from an organic substance as calculated by Equation 1 below:

[Equation 1]
$$Rm/e = \frac{Dm}{De} \times 100(\%)$$

In the Equation 1, a De value is a number of defects detected from a top surface of a substrate after polishing the top surface with the polishing composition for the semiconductor process and etching back the top surface, and a Dm value is a number of defects derived from the organic substance among 100 defects randomly selected from the defects detected from the top surface after the polishing and etching back of the top surface. In these cases, polished and etched surfaces can prevent contamination by particles, especially organic particles.

**Description**

This application claims the priority benefit of Korean Patent Application No. 10-2023-0151792, filed on November 6, 2023.

**BACKGROUND**

1. Field

The present disclosure relates to a polishing composition for a semiconductor process and a method of manufacturing a substrate using the same.

2. Description of the Background

As semiconductor devices are becoming finer and denser, finer patterning techniques are being employed, resulting in complex surface structures of semiconductor devices and frequent defects due to interlayer film steps. In the manufacture of semiconductor devices, chemical mechanical polishing (CMP) is used as a planarization technique to remove steps in certain films formed on the substrate.

In the CMP process, a substrate is pressed and rotated against a polishing pad while a slurry is applied to the pad to polish the surface. The properties of the slurry used vary depending on a target to be polished in the stage of the semiconductor device fabrication process.

Polishing after forming a metal wiring requires sufficient polishing rate and flatness while minimizing dishing or erosion.

**SUMMARY**

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a polishing composition for a semiconductor process includes polishing particles, a polishing pad protectant, and a fluorinated surfactant. The polishing composition has an Rm/e value of 2.5 % or less, which is a ratio of number of defects derived from an organic substance as calculated by Equation 1 below.

[Equation 1]

$$Rm/e = \frac{Dm}{De} \times 100(\%)$$

In the Equation 1, a De value is a number of defects detected from a top surface of a substrate after polishing the top surface with the polishing composition for the semiconductor process and etching back the top surface, and a Dm value is a number of defects derived from the organic substance among 100 defects randomly selected from the defects detected from the top surface after the polishing and etching back of the top surface.

The polishing pad protectant may include a sugar alcohol.

The sugar alcohol may be one selected from the group consisting of sorbitol, mannitol, galactitol, fucitol, iditol, inositol, arabitol, xylitol, erythritol, threitol, and combinations thereof.

The fluorinated surfactant may be a compound represented by Formula 1 below.

[Formula 1]        $R_f(R_{en}\text{-}O)_n\text{-}H$

In the Formula 1, $R_f$ is a fluoroalkyl group having a carbon number from 3 to 10, $R_{en}$ is an alkylene group having a carbon number of 2 or 3, and n is an integer from 2 to 15.

The polishing composition may include from 1 wt% to 5 wt% of the polishing pad protectant.

The polishing composition may include from 10 ppm (by weight) to 500 ppm (by weight) of the fluorinated surfactant.

The polishing composition may further include a tungsten inhibitor. The tungsten inhibitor may be one selected from the group consisting of an azole-based compound, an amino acid, and combinations thereof.

The polishing composition may have a pH of 2.5 to 5.

In another general aspect, a method of manufacturing a substrate includes polishing the substrate by applying a polishing composition for a semiconductor a process.

The polishing composition includes polishing particles, a polishing pad protectant, and a fluorinated surfactant. The polishing composition has an Rm/e value of 2.5 % or less, which is a ratio of number of defects derived from an organic substance as calculated by Equation 1 below.

[Equation 1]
$$Rm/e = \frac{Dm}{De} \times 100(\%)$$

In the Equation 1, a De value is a number of defects detected from a top surface of the substrate after polishing the top surface with the polishing composition and etching back the top surface, and a Dm value is a number of defects derived from the organic substance among 100 defects randomly selected from the defects detected from the top surface after the polishing and etching back of the top surface. In these cases, polished and etched surfaces can prevent contamination by particles, especially organic particles.

Other features and aspects will be apparent from the following detailed description and the claims.

**DETAILED DESCRIPTION**

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of this disclosure. For example, the sequences of operations described herein are merely examples, and are not limited to those set forth herein, but may be changed as will be apparent after an understanding of this disclosure, with the exception of operations necessarily occurring in a certain order. Also, descriptions of features that are known in the art may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of this disclosure. Hereinafter, while embodiments of the present disclosure will be described in detail, it is noted that examples are not limited to the same.

As used herein, the terms "about," "substantially," and the like are meant to be used at or near the numerical value when manufacturing and material tolerances inherent in the recited meanings are presented, and to aid in the understanding of the present disclosure, and to prevent unscrupulous infringers from taking unfair advantage of the disclosure where precise or absolute numerical values are recited.

Throughout the disclosure, the term "combination thereof" as used in a Markush-style representation means one or more mixtures or combinations selected from the group of components described in the Markush-style representation and includes one or more selected from the group of components.

Throughout the disclosure, references to "A and/or B" shall mean "A, B, or A and B".

Throughout the disclosure, terms such as "first", "second" or "A", "B" are used to distinguish one from the other unless otherwise indicated.

As used herein, "B being placed on A" means that B is or may be placed on A, with or without other layers located therebetween, and is not to be construed as limited to B being located abutting the surface of A.

In this specification, singular expressions shall, unless otherwise indicated, be construed to include the singular or plural as construed from the context. "--based compound" includes "--compound" and derivatives thereof.

Particles derived from organic substances may form on the surface of the polished surface after polishing and etch back process. These particles may have smeary property while remaining on the surface of the polished surface and generally have an atypical shape. These organic particles may not be readily removed by conventional cleaning processes.

It is believed that the above contamination occurs because the organic substances remaining on the polished surface after the CMP process are not vaporized in the etch back process in a high temperature environment but remain and are adsorbed on the substrate surface.

The inventors of the present disclosure applied a polishing pad protectant and a fluorinated surfactant to the polishing composition and adjusted the Rm/e value of the polishing composition to within a predetermined range in the present disclosure. Through this, the inventors have experimentally confirmed that the number of defects caused by organic particles may be effectively reduced on the polished surface after the polishing and etch-back process and have completed the present disclosure.

Hereinafter, a detailed description will be given of the present disclosure.

A polishing composition for a semiconductor process, according to examples of the present disclosure, may include a polishing particle, a polishing pad protectant, and a fluorinated surfactant.

## Properties of a Polishing Composition

The polishing composition for a semiconductor process may have an Rm/e value of 2.5 % or less, which is a ratio of a number of defects derived from an organic substance as calculated by Equation 1 below.

$$[\text{Equation 1}] \quad Rm/e = \frac{Dm}{De} \times 100(\%)$$

In Equation 1, wherein the De value is the number of defects detected from a top surface of a substrate after polishing the top surface with the polishing composition for the semiconductor process, and etching back the top surface.
The Dm value is the number of defects derived from an organic substance among 100 defects randomly selected from defects detected from the top surface after polishing and etching back.
By adjusting the Rm/e value of the polishing composition to within a predetermined range, degradation of the electrical properties of the device by organic substance may be suppressed. Furthermore, when producing devices with fine patterns, the production yield of the device may be increased more effectively.
The Rm/e value may be measured by the following way.
A substrate, i.e., a wafer having a diameter of 300 mm, is polished with a polishing machine by applying a polishing composition. The substrate has a tungsten film formed on its entire top surface with a thickness of 100 Å to 1,000 Å.
Polishing is performed at a polishing time of 60 seconds, pressure of 2.2 psi, carrier speed of 93 rpm, platen speed of 87 rpm, and slurry flow rate of 300 ml/min. The polishing machine may be, for example, the AP-300 model from CTS, the REFLECTION_LK model from AMAT, or the F_REX300X model from EBARA.
The polished substrate is then etched back. Specifically, the top surface of the substrate is plasma etched with $SF_6$ gas for 1 minute.
After the etch back, the total number of defects formed on the wafer is measured using a defect measurement instrument, and the measured number of defects is designated as the De value.
After the etch back, 100 defects may be randomly selected from the measured defects, and an inline Smayning Electron Microscope (SEM) is used to determine if the defects are organic-derived. Organic-derived defects means particles composed of organic substance. The number of organic-derived defects among the 100 selected defects is measured and the value is designated as the Dm value. The Rm/e value may then be calculated from the De and Dm values determined as above.
The polishing composition may have an Rm/e value of 2.0 % or less. The Rm/e value may be 1.7 % or less. The Rm/e value may be 1.5 % or less. The Rm/e value may be greater than or equal to 0.01 %. In such a case, when applying the polishing composition, organic defects may be suppressed, which may contribute to producing devices with high yields.
The pH of the polishing composition for a semiconductor process may be from 2.5 to 5. The pH may be 3 or more. The pH may be 3.5 or more. In such a case, the polishing properties of the polishing composition to the polishing target surface may be improved. As a result, a lower content of a polishing particle may be applied to the polishing composition, which may contribute to a lower frequency of particle adsorption on a polishing target surface.
The pH of the polishing composition may be measured with a pH meter.
The zeta potential of the polishing composition for a semiconductor process may be from +5 mV to +50 mV. The zeta potential may be greater than or equal to +10 mV. The zeta potential may be +40 mV or less.
The zeta potential of the polishing particle may be +5 mV to +50 mV. The zeta potential may be greater than or equal to +10 mV. The zeta potential may be less than or equal to +40 mV.
In such a case, the polishing composition may exhibit good polishing properties on silicon oxide films with a surface negative charge while exhibiting stable dispersion.
An electrical conductivity of the polishing composition for a semiconductor process may be 20 µS/cm or more. The electrical conductivity may be 40 µS/cm or more. The electrical conductivity may be 70 µS/cm or more. The electrical conductivity may be greater than or equal to 100 µS/cm . The electrical conductivity may be 400 µS/cm or less. In such a case, it may help the polishing composition polish the polishing target surface at an excellent polishing rate.

## Composition of the Polishing Composition

### Polishing particles

The polishing composition may include polishing particles.
The polishing particles may include metal oxide particles and/or silicon oxide particles. The polishing particles may include silica. The polishing particles may include colloidal silica.

The polishing particles may include at least 70 wt% of colloidal silica. The polishing particles may include at least 80 wt% of colloidal silica. The polishing particles may include at least 90 wt% of colloidal silica. The polishing particles may consist essentially of colloidal silica.

The polishing particles may have a positively charged surface. The polishing particles may have a surface modified to have a positively charge. The polishing particles may have a surface modified with a compound having an amine group. The polishing particles may have a surface modified with an amino silane.

The amino silane may be exemplarily one selected from the group consisting of 3-aminopropyltriethoxysilane, bis[(3-triethoxysilyl)propyl]amine, 3-aminopropyltrimethoxysilane, bis[(3-trimethoxysilyl)propyl]amine, 3-aminopropylmethyldiethoxysilane, 3-aminopropylmethyldimethoxysilane, N-[3-(trimethoxysilyl)propyl]ethylenediamine, N-bis[3-(trimethoxysilyl)propyl]-1,2-ethylenediamine, N-[3-(triethoxysilyl)propyl]ethylenediamine, diethylenetriaminopropyltri-methoxysilane, diethylenetriaminopropylmethyldimethoxysilane, diethylaminomethyltriethoxysilane, diethylaminopro-pyltrimethoxysilane, diethylaminopropyltriethoxysilane, dimethylaminopropyltrimethoxysilane, N-[3-(trimethoxysilyl)propyl]butylamine, and combinations thereof.

The polishing composition for a semiconductor process may include 15 ppm (by weight) to 200 ppm (by weight) of amino silane. The polishing composition for a semiconductor process may include 20 ppm or more (by weight) of amino silane. The polishing composition for a semiconductor process may include 25 ppm or more (by weight) of amino silane. The polishing composition for a semiconductor process may include 30 ppm or more (by weight) of amino silane. The polishing composition for a semiconductor process may include 150 ppm or less (by weight) of amino silane. The polishing composition for a semiconductor process may include 100 ppm or less (by weight) of amino silane. The polishing composition for a semiconductor process may include 70 ppm or less (by weight) of amino silane. The polishing composition for a semiconductor process may include 50 ppm or less (by weight) of amino silane. In this case, the polishing composition may have a better polishing rate to the silicon oxide film, provide a more smoothly polished substrate, and exhibit improved dispersibility. At the same time, when a residue of the surface modifier is generated, it may effectively inhibit the adsorption of the residue to the polishing target surface.

The polishing composition for a semiconductor process may include 1 wt% to 10 wt% of the polishing particles. The polishing composition for a semiconductor process may include at least 2 wt% of the polishing particles. The polishing composition for a semiconductor process may include less than or equal to 8 wt% of the polishing particles. The polishing composition for a semiconductor process may include less than or equal to 5 wt% of the polishing particles. In such a case, the polishing composition may have an excellent polishing rate on the polishing target surface while reliably inhibiting agglomeration of the polishing particles.

The polishing particles may have an average particle size of 20 nm or more. The average particle diameter may be 30 nm or more. The average particle diameter may be 40 nm or more. The average particle diameter may be 70 nm or less. The average particle size may be 60 nm or less. The average particle diameter may be 50 nm or less. In such cases, the polishing composition may exhibit a good polishing rate to the polishing target surface while stably controlling the frequency of defects on the polished surface.

The average particle diameter means the average diameter of a primary particle of the polishing particle.

Polishing Pad Protectant

The polishing pad protectant of the present disclosure may effectively reduce the degree of abrasion of the polishing pad during the CMP process, thereby contributing to a reduction in the frequency with which debris from the polishing pad is adsorbed onto the surface of the substrate to be polished.

The polishing pad protectant of the present disclosure may include a sugar alcohol. The sugar alcohol as a polishing pad protectant may adhere to the surface of the polishing pad during the polishing process and reliably protect the polishing pad. Furthermore, since sugar alcohol is difficult to utilize as a nutrient for bacteria, the application of sugar alcohol to the polishing composition may inhibit excessive growth of microorganisms in the composition and effectively inhibit contamination of the device production line by the microorganisms. The sugar alcohol may be any one selected from the group consisting of sorbitol, mannitol, galactitol, fucitol, iditol, inositol, arabitol, xylitol, erythritol, threitol, and combinations thereof. The sugar alcohol may be sorbitol.

The polishing pad protectant may include at least 50 wt% of sugar alcohol. The polishing pad protectant may include at least 60 wt% of sugar alcohol. The polishing pad protectant may include at least 70 wt% sugar alcohol. The polishing pad protectant may include less than or equal to 100 wt% sugar alcohol. The pad protectant may be the sugar alcohol.

The polishing composition for a semiconductor process may include from 1 wt% to 5 wt% of the polishing pad protectant. The polishing composition for a semiconductor process may include more than 1.5 wt% of the polishing pad protectant. The polishing composition for a semiconductor process may include less than or equal to 4 wt% of the polishing pad protectant. When applied to a polishing process, these polishing compositions may inhibit contamination of the polished substrate surface with organic-derived particles.

Fluorinated Surfactant

A fluorinated surfactant may be applied to the polishing composition. The surfactant may be adsorbed on the debris surface of the polishing pad generated during the polishing process. The adsorbed surfactant may further increase the hydrophilicity of the debris. This may effectively prevent the debris from being adsorbed on the surface of the polishing target surface. Furthermore, the fluorine groups contained in the fluorinated surfactant may help kill bacteria and other microorganisms in the polishing composition and contribute to reducing the number of defects caused by organic particles detected on the polished surface.

The fluorinated surfactants may be a fluoroalkyl alkylene oxide-based compound. The fluorinated surfactant may be a compound represented by Formula 1 below.

$$[\text{Formula 1}] \qquad R_f\text{-}(R_{en}\text{-}O)_n\text{-}H$$

In Formula 1, wherein $R_f$ is a fluoroalkyl group having a carbon number from 3 to 10, $R_{en}$ is an alkylene group having a carbon number of 2 or 3, and n is an integer from 2 to 15.

In Formula 1 above, $R_f$ may be a perfluoroalkyl group having a carbon number from 3 to 10.

The fluorinated surfactant may be a polymeric surfactant. The fluorinated surfactant may have a weight average molecular weight from 150 g/mol to 3,000 g/mol. The weight average molecular weight may be 300 g/mol or more. The weight average molecular weight may be 500 g/mol or more. The weight average molecular weight may be 2500 g/mol or less. The weight average molecular weight may be 2000 g/mol or less. The weight average molecular weight may be 1500 g/mol or less.

Fluorinated surfactants with the above characteristics may have a controlled main chain length, which enables efficient evacuation of the polishing pad debris. This also prevents an excessive increase in the dispersibility of the polishing composition.

The weight average molecular weight of polymeric surfactants may be measured by gel permeation chromatography (GPC).

The content of the fluorinated surfactant may be adjusted to within a predetermined range. This may inhibit the adhesion of organic particles to the polished surface after polishing, while preventing excessive foaming of the polishing composition during the polishing process, which may result in poor processability.

The polishing composition for a semiconductor process may include 10 ppm (by weight) or more of the fluorinated surfactant. The polishing composition for a semiconductor process may include 20 ppm or more (by weight) of the fluorinated surfactant. The polishing composition for a semiconductor process may include 50 ppm or more (by weight) of the fluorinated surfactant. The polishing composition for a semiconductor process may include 100 ppm or more (by weight) of the fluorinated surfactant. The polishing composition for a semiconductor process may include 150 ppm or more (by weight) of the fluorinated surfactant. The polishing composition for a semiconductor process may include 500 ppm or less (by weight) of the fluorinated surfactant. The polishing composition for a semiconductor process may include 450 ppm or less (by weight) of the fluorinated surfactant. In this case, it may effectively increase the hydrophilicity of the polishing pad debris while suppressing excessive foaming during the polishing process.

Tungsten Inhibitor

The polishing composition for a semiconductor process may further include a tungsten inhibitor.

In a tungsten film, organic particles such as bacteria or microorganisms may be adsorbed on the surface of the film more frequently than other thin films. In the polishing composition of the present disclosure, a tungsten inhibitor may adhere to the surface of the tungsten film during the polishing process. The tungsten inhibitor may effectively prevent organic particles from adhering to the tungsten film and inhibit excessive corrosion of the tungsten film.

The tungsten inhibitor may be any one selected from the group consisting of azole-based compounds, amino acids, and combinations thereof.

The azole-based compound may be a five-membered heterocyclic compound, and/or a derivative thereof, containing a nitrogen atom in the ring, and at least one non-carbon atom.

The azole-based compound may include triazole, benzotriazole, imidazole, pyrazole, tetrazole, aminotetrazole, pentazole, oxazole, isoxazole, oxadiazole, furazan, thiazole, isothiazole, thiadiazole, derivatives thereof, and combinations thereof.

The amino acid may be any one selected from the group consisting of glycine, threonine, arginine, aspartic acid, cystine, cysteine, glutamine, glutamic acid, histidine, isoleucine, leucine, alpha-alanine, lysine, methionine, phenylalanine, proline, serine, tryptophan, tyrosine, valine, and combinations thereof. The amino acid may be glycine.

The polishing composition for a semiconductor process may include 0.01 wt% to 0.5 wt% of the tungsten inhibitor. The polishing composition for a semiconductor process may include 0.02 wt% or more of the tungsten inhibitor. The polishing composition for a semiconductor process may include 0.3 wt% or less of the tungsten inhibitor. The polishing composition for a semiconductor process may include 0.2 wt% or less of the tungsten inhibitor. The polishing composition for a semiconductor process may include 0.1 wt% or less of the tungsten inhibitor. In this case, corrosion of the tungsten film may be prevented while inhibiting the adsorption of organic foreign matter to the surface of the tungsten film. Furthermore, the pH of the polishing composition may be prevented from becoming excessively high due to the tungsten inhibitor, thereby reducing the polishing properties of the polishing composition on the silicon oxide film also may be prevented.

Other Additives

The polishing composition for a semiconductor process may further include other additives. The additive is not limited to those commonly applied in the field of CMP. For example, the additive may be at least one of an oxidizing agent, an acid component, a pH adjuster, a dispersant, a polishing rate enhancer, a polishing regulator, and a preservative.

The polishing composition for a semiconductor process may further include an oxidizing agent. The oxidizing agent may oxidize metals such as tungsten to create an environment that makes it easier to polish the substrate surface, and improve polishing rate and etching rate.

Oxidizer may be one selected from the group of hydrogen peroxide, urea peroxide, urea, percarbonate, periodic acid, periodate, perchloric acid, perchlorate, perchloric acid, perbromic acid, perbromate, perboric acid, perborate, , permanganic acid, permanganate, persulfate, bromate, chlorate, chlorite, chromate, iodate, iodic acid, ammonium persulfate, benzoyl peroxide, calcium peroxide, barium peroxide, sodium peroxide, peroxide, and combinations thereof.

The polishing composition for a semiconductor process may include 0.01 wt% to 5 wt% of the oxidizing agent. In such a case, the polishing composition may exhibit good polishing properties on the metal and may inhibit the formation of an oxide film on the metal to be polished during the polishing process.

The polishing composition for a semiconductor process may further include an acid component. The acid component may be, for example, hydrochloric acid, phosphoric acid, sulfuric acid, hydrofluoric acid, bromic acid, iodic acid, formic acid, malonic acid, maleic acid, oxalic acid, acetic acid, adipic acid, citric acid, propionic acid, fumaric acid, lactic acid, salicylic acid, pimelin, benzoic acid, succinic acid, phthalic acid, butyric acid, glutaric acid, glutamic acid, glutamine acid, glycolic acid, asparagine acid, tartaric acid, salts thereof, and combinations thereof.

The polishing composition for a semiconductor process may further include a pH adjuster in addition to the acid component. The pH adjuster may be, for example, any one selected from the group consisting of ammonia, aminomethylpropanol, tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The polishing composition for a semiconductor process may further include a dispersant.

The dispersant may prevent agglomeration of the polishing particles and uniformly disperse the polishing particles within the polishing composition. A cationic dispersant may positively increase the zeta potential of the polishing composition, while anionic dispersants may negatively decrease the zeta potential of the polishing composition.

The dispersant may include an anionic small molecule, a cationic polymer, an organic acid or the like.

The anionic small molecule of the dispersant may be one selected from oxalic acid, citric acid, polysulfonic acid, polyacrylic acid, polymethacrylic acid, and combinations thereof.

The cationic polymer of the dispersant may be one selected from polylysine, polyethyleneimine, benzethonium chloride, bronidox, cetrimonium bromide, cetrimonium chloride, dimethyldioctadecylammonium chloride, tetramethylammonium hydroxide, distearyldimethylammonium chloride, polyarylamine, and combinations thereof.

The organic acid as the dispersant may be one selected from hydroxylbenzoic acid, ascorbic acid, picolinic acid, glutamic acid, tryptophan, aminobutyric acid, and combinations thereof.

The polishing rate enhancer is an additive for increasing the polishing rate for a substrate or wiring to be polished, and may be one selected from potassium nitrate, iron nitrate, ammonium hydroxide, citric acid, acetic acid, and combinations thereof.

The polishing regulator is a component that minimizes the adsorption of the polishing composition to a metal surface. The polishing regulator may include ammonium compounds, potassium nitrate, amino acids, salts thereof and the like.

The polishing composition for a semiconductor process may include a solvent. The solvent may be water, and more particularly may be ultrapure water.

**Polishing Properties of Polishing Composition**

A polishing rate for a silicon oxide film of the polishing composition for a semiconductor process may be 1000 Å/min or more. The polishing rate may be 1100 Å/min or more. The polishing rate may be 1200 Å/min or more. The polishing rate may be 3000 Å/min or less. The polishing rate may be 2500 Å/min or less. The polishing rate may be 2000 Å/min or less.

A polishing rate for a tungsten film of the polishing composition for a semiconductor process may be 50 Å/min or more. The polishing rate may be 70 Å/min or more. The polishing rate may be 500 Å/min or less. The polishing rate may be 300 Å/min or less. The polishing rate may be 200 Å/min or less.

A polishing selectivity ratio of the silicon oxide film to the tungsten film of the polishing composition for a semiconductor process may be 5 or more. The polishing selectivity ratio may be 6 or more. The polishing selectivity ratio may be 7 or more. The polishing selectivity ratio may be 20 or less.

In such a case, the polishing composition may exhibit a good silicon oxide polishing rate relative to tungsten polishing rate.

The Ra value of the tungsten film measured after polishing for 30 seconds with the polishing composition for a semiconductor process may be 3 nm or less. The Ra value may be 2 nm or less. In such a case, the polishing composition may provide a polished surface having a smoother surface. Ra value is measured according to ISO 4287.

Polishing for each thin film may be performed at a pressure of 2.2 psi, carrier speed of 87 rpm, platen speed of 93 rpm, and slurry flow rate of 250 ml/min. The polishing pad may be the SR-300 model from SK enpulse Co., Ltd.

To measure the polishing rate for each thin film, a polishing machine may be used, for example, the AP-300 model from CTS.

## Method of Manufacturing a Substrate

A method of manufacturing a substrate of the present disclosure may includepolishing the substrate by applying a polishing composition for a semiconductor process as a slurry.

The substrate may include at least one of an insulating film, metal wiring, and a barrier layer on a top surface of the substrate. The metal wiring may include copper or tungsten. If the metal wiring includes copper, the barrier layer may include tantalum and nitrides thereof. If the metal wiring includes tungsten, the barrier layer may include titanium and nitrides thereof.

Specifically, the process of polishing the substrate may be performed by contacting the substrate to be polished with the polishing composition for a semiconductor process supplied from a spray nozzle onto a polishing pad, while the polishing head holding the substrate is rotated and the platen to which the polishing pad is attached is also rotated.

The method of manufacturing the substrate may include polishing an exposed tungsten film on a top surface of the substrate with the polishing composition for a semiconductor process for a time of 5 seconds to 20 seconds (partial CMP).

A method of manufacturing the substrate may include polishing a tungsten bulk film formed on a top surface of the substrate with the polishing composition for a semiconductor process to separate nodes.

The process of polishing the substrate may further include, if desired, conditioning the surface of the polishing pad prior to polishing.

The polishing composition for a semiconductor process may polish a wafer in contact with a polishing pad as it penetrates toward the substrate.

When polishing the substrate, a pressure of 6.89 kPa to 48.26 kPa may be applied. The pressure may be from 13.79 kPa to 34.47 kPa.

Polishing the substrate may be performed from 50 seconds to 10 minutes. However, the duration may vary depending on the degree of polishing desired.

The polishing composition for a semiconductor process described above may be applied to the method of manufacturing the substrate. The description of the polishing composition for a semiconductor process is omitted as it is redundant to the previous discussion.

The method of manufacturing the substrate may further include cleaning the polished substrate.

The cleaning may be carried out by flushing the polished substrate with purified water and/or inert gas.

Specific examples will be described in more detail below. The following examples are illustrative only to aid in understanding the disclosure and are not intended to limit the scope of the present disclosure.

## Manufacturing Example: Preparation of Polishing Compositions

Example 1: In ultrapure water as solvent, 3 wt% of colloidal silica with modified surface by 38 ppm (by weight) of (3-aminopropyl) triethoxysilane as a polishing particle, 2 wt% of sorbitol as a polishing pad protectant, and 50 ppm (by weight) of Capstone's FS 3100 as a fluorinated surfactant were added and mixed to prepare a total of 100 wt% of a polishing composition.

Example 2: A total of 100 wt% polishing composition was prepared under the same conditions as in Example 1, except that an additional 0.05 wt% of glycine was further added to the polishing composition as a tungsten inhibitor, and the average particle size of the polishing particle, pH, electrical conductivity, and zeta potential of the polishing composition were applied as listed in Table 1.

Example 3: A total of 100 wt% polishing composition was prepared under the same conditions as in Example 1, except that the average particle size of the polishing particle, pH, electrical conductivity, and zeta potential of the polishing composition were applied as listed in Table 1.

Comparative Example 1: A total of 100 wt% polishing composition was prepared under the same conditions as Example 1, except that 1 wt% sorbitol and 2 wt% sucrose were applied as pad protectants, and 0.05 wt% aminotetrazole, 0.05 wt% glycine, and 0.05 wt% imidazole were added as tungsten inhibitors, and the average particle size of the polishing particle, pH, electrical conductivity, and zeta potential of the polishing composition were applied as shown in Table 1.

Comparative Example 2: A total of 100 wt% polishing composition was prepared under the same conditions as in Comparative Example 1, except that the fluorinated surfactant was applied at 25 ppm (by weight) and the average particle size of the polishing particle, pH, electrical conductivity, and zeta potential of the polishing composition were applied as listed in Table 1.

The content of each component in the polishing composition and the average particle size (primary particle size) of the polishing particle of each Example and Comparative Example are shown in Table 1 below, and the pH, electrical conductivity, and zeta potential of the polishing composition are shown in Table 2 below.

Evaluation Example: **Determination of the Number of Defects on the Polished Surface and the Polishing rate of the Polishing Composition**

The top surface of a 300 mm diameter wafer was polished with a CTS AP-300 polishing machine by applying the polishing compositions of the Examples and Comparative Examples. The wafer has a tungsten film formed on the entire top surface with a thickness of 100 Å to 1,000 Å.

The polishing was performed at a polishing time of 60 seconds, pressure of 2.2 psi, carrier speed of 93 rpm, platen speed of 87 rpm, and slurry flow rate of 300 ml/min.

In etch-back process, the polished wafers were plasma etched with $SF_6$ gas for 1 minute.

After etching back, the total number of defects formed on the wafer was measured using defect measurement equipment, and the above measurement is designated as a De value.

Then, 100 defects were randomly selected from the measured defects, and an inline scanning electron microscope (SEM) was used to judge that the selected defects were organic-derived, i.e., organic particles or not. The number of organic-derived defects among the 100 selected defects was measured, and the value was designated as a Dm value.

The Rm/e value was calculated from the De and Dm values above.

The measured values and calculated values for each of the above Examples and Comparative Examples are listed in Table 3 below.

Then, the height difference between the tungsten film and the silicon oxide film before and after polishing was measured from the wafers, and polishing rates for the tungsten film and the silicon oxide film between the tungsten film and the silicon oxide film were calculated from the measured values.

The measured values and calculated values for each of the above Examples and Comparative Examples are listed in Table 2 below.

**Evaluation Example: Measuring Pad Wear Rate**

The height of the polishing pad, model SR-300 of SK enpulse Co., Ltd., was measured using a profiler. Then, the tungsten film formed on the top surface of the wafer with a diameter of 300 mm was continuously polished with an AP-300 polishing machine of CTS by applying the polishing pad and the polishing composition of the Examples and Comparative Examples.

Polishing was performed at a pressure of 2.2 psi, carrier speed of 93 rpm, platen speed of 87 rpm, and slurry flow rate of 300 ml/min. During polishing, the CMP process was performed without changing the polishing pads until the cumulative polishing process time reached 20 hours.

After polishing, the height of the polishing pad was measured with a profiler.

The height difference of the polishing pad before and after polishing was calculated, and the height difference was divided by the polishing time to calculate the pad wear rate.

The calculations for each Example and Comparative Example are shown in Table 3 below.

**Evaluation Example: Measuring Bubble Generation**

3 L of the polishing composition for each Example and Comparative Example was added to a 5 L volume glass reactor. The polishing composition was stirred at a speed of 1,000 RPM for 30 minutes at 25 °C with a 4-lobed blade with a total length of 10 cm. 10 minutes after the end of stirring, the height of the bubbles formed in the glass reactor was measured. The volume of the bubbles was calculated from the above height value and the internal diameter of the glass reactor containing the polishing composition.

The calculated bubble volume values for the Examples and Comparative Examples are shown in Table 3 below.

[Table 1]

| | A polishing particle Content (wt%) | Average Diameter of a polishing particle (nm) | Polishing Pad Protectant | | Surfactant (ppm, by weight) | Tungsten Inhibitor | | |
| --- | --- | --- | --- | --- | --- | --- | --- | --- |
| | | | Sorvitol (wt%) | Sucrose (wt%) | | Aminotetrazole (wt%) | Glycine (wt%) | Imidazole (wt%) |
| Example 1 | 3 | 44.21 | 2 | 0 | 50 | - | - | -- |
| Example 2 | 3 | 44.63 | 2 | 0 | 50 | - | 0.05 | - |
| Example 3 | 3 | 45.27 | 2 | 0 | 50 | - | - | - |
| Comparative Example 1 | 3 | 44.34 | 1 | 2 | 50 | 0.05 | 0.05 | 0.05 |
| Comparative Example 2 | 3 | 44.69 | 1 | 2 | 25 | 0.05 | 0.05 | 0.05 |

[Table 2]

| | pH | Electrical Conductivity (μS/cm) | Zeta Potential (eV) | Polishing Rate for Silicon Oxide Film (Å/min) | Polishing Rate for Tungsten Film (Å/min) | Polishing Selectivity Ratio of Silicon Oxide Film to Tungsten Film |
| --- | --- | --- | --- | --- | --- | --- |
| Example 1 | 4.26 | 53.3 | 14.5 | 1468 | 153 | 9.59 |
| Example 2 | 3.85 | 109.8 | 16.6 | 1139 | 141 | 8.08 |
| Example 3 | 3.78 | 117.6 | 25.0 | 1045 | 161 | 6.49 |
| Comparative Example 1 | 4.20 | 100.0 | 15.2 | 1329 | 144 | 9.23 |
| Comparative Example 2 | 4.20 | 184.9 | 22.4 | 1321 | 179 | 7.38 |

[Table 3]

| | Rm/e (%) | Pad Wear Rate (μm/hr) | Bubble Volume (ml) |
| --- | --- | --- | --- |
| Example 1 | 0.88 | 32.8 | 30 |
| Example 2 | 0.50 | 32.5 | 25 |
| Example 3 | 0.45 | 28.6 | 30 |
| Comparative Example 1 | 2.71 | 35.7 | 50 |
| Comparative Example 2 | 3.19 | 33.1 | 20 |

In Table 3 above, for Rm/e values, Examples 1 to 3 exhibited values of 1 % or less, while Comparative Examples 1 and 2 exhibited values of 2.5 % or more.

For the pad wear rate, the Examples exhibited lower values than the Comparative Examples.

With respect to the volume of bubbles, Examples 1 to 3 exhibited values of 30 ml or less. This means that the polishing composition described in the present disclosure, the amount of foaming during the polishing process may be controlled below a certain level.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents. Therefore, the scope of the disclosure is defined not by the detailed description, but by the claims and their equivalents, and all variations within the scope of the claims and their equivalents are to be construed as being included in the disclosure.

**Claims**

1. A polishing composition for a semiconductor process, the polishing composition comprising:

   polishing particles;
   a polishing pad protectant; and
   a fluorinated surfactant,
   wherein the polishing composition has an Rm/e value of 2.5 % or less, which is a ratio of a number of defects derived from an organic substance as calculated by Equation 1 below;

   [Equation 1]

   $$Rm/e = \frac{Dm}{De} \times 100(\%)$$

   wherein in the Equation 1, a De value is a number of defects detected from a top surface of a substrate after polishing the top surface with the polishing composition for the semiconductor process and etching back the top surface, and
   wherein a Dm value is a number of defects derived from the organic substance among 100 defects randomly selected from the defects detected from the top surface after the polishing and etching back of the top surface.

2. The polishing composition for a semiconductor process of claim 1, wherein the polishing pad protectant comprises a sugar alcohol.

3. The polishing composition for a semiconductor process of claim 2, wherein the sugar alcohol is one selected from the group consisting of sorbitol, mannitol, galactitol, fucitol, iditol, inositol, arabitol, xylitol, erythritol, threitol, and combinations thereof.

4. The polishing composition for a semiconductor process of claim 1, wherein the fluorinated surfactant is a compound represented by Formula 1 below;

   [Formula 1]       $R_f(R_{en}\text{-}O)_n\text{-}H$

   In the Formula 1, $R_f$ is a fluoroalkyl group having a carbon number from 3 to 10, $R_{en}$ is an alkylene group having a carbon number of 2 or 3, and n is an integer from 2 to 15.

5. The polishing composition for a semiconductor process of claim 1, wherein the polishing composition comprises from 1 wt% to 5 wt% of the polishing pad protectant.

6. The polishing composition for a semiconductor process of claim 1, wherein the polishing composition comprises from 10 ppm (by weight) to 500 ppm (by weight) of the fluorinated surfactant.

7. The polishing composition for a semiconductor process of claim 1, further comprising a tungsten inhibitor, wherein the tungsten inhibitor is one selected from the group consisting of an azole-based compound, an amino acid, and combinations thereof.

8. The polishing composition for a semiconductor process of claim 1, wherein the polishing composition has a pH of 2.5 to 5.

9. A method of manufacturing a substrate, the method comprising:
   polishing the substrate by applying a polishing composition for a semiconductor process, the polishing composition comprising:

polishing particles;
a polishing pad protectant; and
a fluorinated surfactant,
wherein the polishing composition has an Rm/e value of 2.5 % or less, which is a ratio of a number of defects derived from an organic substance as calculated by Equation 1 below;

[Equation 1] $$Rm/e = \frac{Dm}{De} \times 100(\%)$$

wherein in the Equation 1, a De value is a number of defects detected from a top surface of the substrate after polishing the top surface with the polishing composition and etching back the top surface, and
wherein a Dm value is a number of defects derived from the organic substance among 100 defects randomly selected from the defects detected from the top surface after the polishing and etching back of the top surface.

Europäisches
Patentamt

European
Patent Office

Office européen
des brevets

# EUROPEAN SEARCH REPORT

Application Number

EP 24 21 0849

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/227696 A1 (HONG SEUNG CHUL [KR] ET AL) 20 July 2023 (2023-07-20) * paragraphs [0061], [0110], [0159] - [0176]; claims 1-20; tables 1, 2 * | 1-9 | INV. C09G1/02 C09K3/14 |
| X | HONG SEUNGCHUL ET AL: "Zeta potential-tunable silica abrasives and fluorinated surfactants in chemical mechanical polishing slurries", WEAR, ELSEVIER SEQUOIA, LAUSANNE, CH, vol. 466, 10 December 2020 (2020-12-10), XP086475111, ISSN: 0043-1648, DOI: 10.1016/J.WEAR.2020.203590 [retrieved on 2020-12-10] * paragraphs "2. Experimental" and "3. Results and discussion"; pages 2-7; figures 1-10 * | 1-5,7-9 | |
| T | US 2024/218251 A1 (HONG SEUNG CHUL [KR] ET AL) 4 July 2024 (2024-07-04) * paragraphs [0082] - [0084] * | 1-9 | TECHNICAL FIELDS SEARCHED (IPC) C09G F16D C09K |

The present search report has been drawn up for all claims

| Place of search | Date of completion of the search | Examiner |
|---|---|---|
| Munich | 26 February 2025 | Schmitt, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 21 0849

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2025

| Patent document cited in search report | Publication date | Patent family member(s) | | Publication date |
|---|---|---|---|---|
| US 2023227696 A1 | 20-07-2023 | CN | 116515400 A | 01-08-2023 |
| | | JP | 7572470 B2 | 23-10-2024 |
| | | JP | 2023106354 A | 01-08-2023 |
| | | KR | 20230112263 A | 27-07-2023 |
| | | TW | 202330826 A | 01-08-2023 |
| | | US | 2023227696 A1 | 20-07-2023 |
| US 2024218251 A1 | 04-07-2024 | CN | 118291042 A | 05-07-2024 |
| | | KR | 20240109403 A | 11-07-2024 |
| | | TW | 202428807 A | 16-07-2024 |
| | | US | 2024218251 A1 | 04-07-2024 |

EPO FORM P0459

For more details about this annex : see Official Journal of the European Patent Office, No. 12/82

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230151792